# FASCICULE DE BREVET EUROPEEN

(11) **EP 0 409 672 B1**
(45) Date de publication et mention de la délivrance du brevet: **31.08.1994**
(21) Numéro de dépôt: 90401531.0
(22) Date de dépôt: 06.06.1990
(51) Int. Cl.: G11C 16/06

(54) **Procédé d'effacement de points mémoire, dispositif destiné à sa mise en oeuvre, et son utilisation dans un dispositif à mémoire non alimenté**
Löschverfahren für Speicherzellen, Ausführungsvorrichtung hierfür und seine Anwendung in einer stromlosen Speichervorrichtung
Erasing procedure for memory cells, means for its implementation and its use in a powerless memory device

(30) Priorité: 06.06.1989 FR 8907467
(43) Date de publication de la demande: 23.01.1991
(73) Titulaire: GEMPLUS CARD INTERNATIONAL, F-13420 Gémenos (FR)
(72) Inventeur: Farrugia, Augustin, F-75116 Paris (FR); Binguy, Gérard, F-75116 Paris (FR)
(74) Mandataire: Schmit, Christian Norbert Marie

(56) Documents cités:
- EP-A- 0 123 177
- PATENT ABSTRACTS OF JAPAN, vol. 2, no. 64 (P-2197), 17 mai 1978, page E 78.
- PATENT ABSTRACTS OF JAPAN, vol. 7, no. 42 (P-177)[1187], 19 février 1983.

## Description

L'invention se rapporte aux circuits intégrés à mémoire, et plus particulièrement aux mémoires programmables et effaçables électriquement, et notamment à leur effacement.

Une mémoire programmable et effaçable électriquement "EEPROM" est une mémoire "morte" c'est-à-dire conservant les informations qui y ont été stockées, même lorsqu'elle n'est plus alimentée. Une telle mémoire a également la particularité de pouvoir être effacée octet par octet, par exemple, au moyen d'une impulsion électrique. Les termes "programmation" et "effacement" sont utilisés dans la suite conformément a une convention habituellement utilisée pour les produits EPROM.

Comme il sera expliqué ci-après, l'effet d'inscription et d'effacement électrique est obtenu par extraction de charges du substrat et stockage sous une grille flottante, et retour au substrat de ces mêmes charges par effet tunnel. Mais comme il sera expliqué plus en détail ci-après, ce phénomène n'est pas éternel : après un certain nombre de cycles d'écriture et d'effacement, la cellule, c'est à dire l'élément mémoire de base contenant une information élémentaire, vient progressivement à se dégrader jusqu'à ce que ses constituants physiques l'empêchent d'assurer correctement les fonctions d'écriture ou d'effacement.

Jusqu'à présent, dans les applications utilisant des composants EEPROM sujets à de fréquentes mises à jour, les défaillances ont été constatées après un nombre d'utilisations inconnu et variable. Lorsque ce genre de problème se produit, toujours en cours d'application, des inconvénients majeurs peuvent intervenir. Pour vérifier l'exactitude des informations modifiées après un cycle d'écriture ou d'effacement, l'application est astreinte à une relecture systématique. Au cas où la relecture signalerait après une écriture une anomalie, on procède à une réécriture des modifications, et ceci jusqu'à ce que la relecture soit correcte. Il est connu de réécrire un certain nombre de fois les informations à enregistrer. Ce nombre dépend de la technologie de la mémoire. Un même problème se présente pour l'effacement : l'effacement doit lui aussi être réitéré. Seulement, concernant l'effacement, le nombre de réitérations évolue dans le temps ou avec l'utilisation de la mémoire.

Pour obtenir des conditions de fonctionnement toujours convenables, il serait possible d'envisager de compter dans un compteur le nombre de cycles d'effacement - lecture et d'effectuer une vérification en déclarant le composant hors d'usage dès que ce nombre dépasse un seuil déterminé à l'avance qui devrait dans ce cas être assez bas pour éviter tout risque de panne. Mais ces mémoires se trouvant en général dans des contextes non alimentés, cartes à puces, appareils portables, sauvegardes de configuration..., il serait nécessaire de loger ce compteur sur la mémoire EEPROM elle-même, et ce compteur serait alors davantage sollicité que ce qu'il compte. Ce compteur réalisé dans la même technologie que les cellules mémoires, est naturellement soumis aux mêmes défaillances.

De plus, le nombre critique de cycles au delà duquel une mémoire EEPROM est en défaut, est malheureusement impossible à déterminer à l'avance : il est variable d'une technologie de fabrication à l'autre, d'un produit à l'autre à l'intérieur d'une même technologie de fabrication, d'un composant à l'autre à l'intérieur d'un produit selon des paramètres éventuellement connus, mais souvent non maîtrisables comme la température, le temps ou la tension de programmation...

Cependant, les essais ont montré que le comportement des cellules consécutivement à des défauts était toujours sensiblement le même.

L'invention a pour objet un procédé d'effacement de points mémoire prenant en compte ces défauts, pour d'une part, obtenir dans tous les cas possibles l'effacement désiré, et pour, d'autre part avertir l'application utilisant le point mémoire des défauts rencontrés dans les cycles d'effacement.

Selon l'invention, on met en oeuvre un procédé d'effacement de point mémoire EEPROM, caractérisé en ce qu'il consiste :
- à ouvrir et initialiser un compteur dans une mémoire à accès aléatoire associée au processeur de commande d'effacement au début de chaque opération d'effacement d'un point mémoire,
- à effectuer un cycle d'effacement, puis un cycle de lecture et une comparaison de la tension lue avec une tension attendue correspondant à l'état effacé,
- à déclencher lorsque les deux tensions sont différentes l'itération du compteur et un nouveau cycle d'effacement et lecture, puis une comparaison, tant que le contenu du compteur reste inférieur à un nombre prédéterminé,
- à commander l'émission d'un code retour vers l'application fonction du contenu du compteur et donc du nombre de cycles d'effacement nécessaires à l'opération d'effacement, lorsque la tension lue est la tension attendue après au moins 2 cycles d'effacement, ainsi que lorsque le contenu du compteur a atteint le nombre prédéterminé.

L'invention a également pour objet un dispositif destiné à la mise en oeuvre de ce procédé d'effacement. Le dispositif est décrit dans la revendication 3.

L'invention a également pour objet l'utilisation de ce procédé d'effacement de points mémoire dans les dispositifs à mémoire non alimentés, selon la revendication 4.

L'invention sera mieux comprise et d'autres caractéristiques apparaîtront à l'aide de la description qui suit en référence aux figures annexées.
La figure 1 est le schéma d'un point mémoire MOS en phase d'écriture ;
La figure 2 est le schéma d'un point mémoire MOS en phase d'effacement ;
La figure 3 est le schéma d'un point mémoire MOS dans lequel un défaut d'effacement existe ;
La figure 4 est un organigramme du procédé d'effacement de point mémoire EEPROM selon l'invention.
La figure 5 est un schéma du dispositif destiné à la mise en oeuvre du procédé d'effacement, selon l'invention.

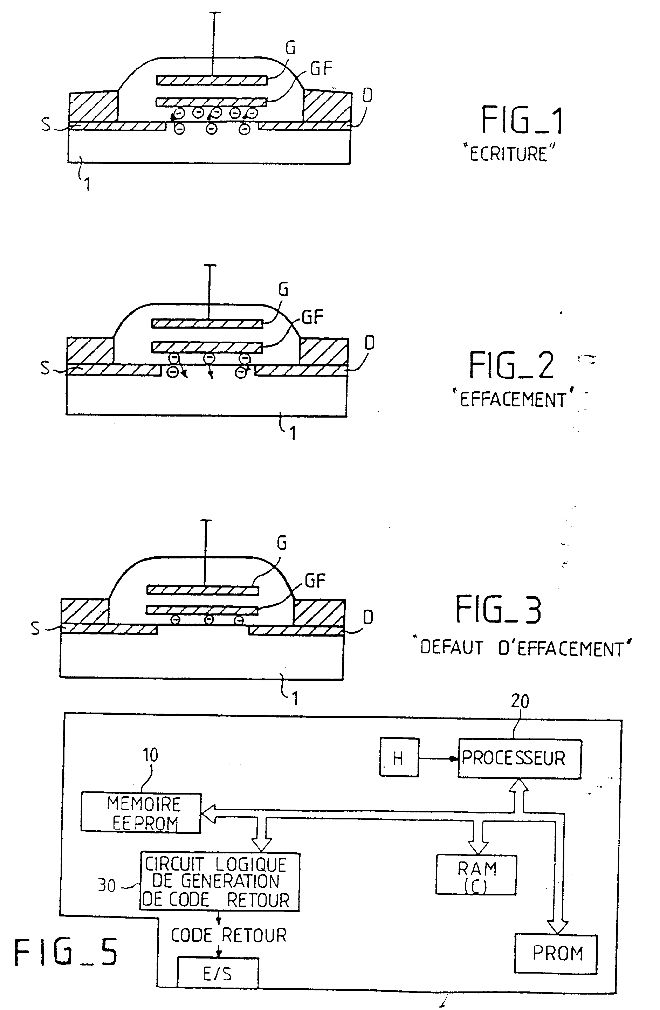

Les trois figures 1, 2 et 3 représentent la même structure de base de la cellule mémoire en coupe, c'est à dire le substrat semi conducteur ,1, les électrodes de source S et de drain D séparées par un canal dans le substrat, cet ensemble étant recouvert d'oxyde isolant, d'une grille dite grille flottante GF parce que non connectée, séparée d'une grille de commande G par une autre couche d'oxyde, la grille G étant recouverte d'isolant oxyde. Dans la phase d'écriture, sur la figure 1, une impulsion de grande amplitude appliquée sur la grille de commande G permet par exemple d'extraire des électrons du substrat et de les stocker sous la grille flottante GF, ces électrons traversant la barrière isolante qui les sépare de la grille flottante par un effet tunnel sur le drain.

Dans la phase d'effacement représentée sur la figure 2, par application d'une impulsion en sens contraire, les charges stockées sous la grille flottante GF reviennent au substrat toujours par effet tunnel. Le point mémoire est dans un état stable après une phase d'écriture les charges étant piégées sous la grille flottante GF, et après l'effacement, les charges étant ramenées au substrat. Cependant, du fait du vieillissement occasionné par une nombre important de cycles d'effacement et d'écriture, des pièges électroniques se créent dans la couche d'oxyde isolante entre le substrat et la grille flottante, et lors de l'effacement des électrons restent piégés. C'est ce qui est représenté sur la figure 3. La cellule a alors tendance à être vue toujours programmée alors qu'en fait elle a été effacée, du fait que des charges sont restées dans l'isolant, ce qui a pour effet d'augmenter la tension de seuil du transistor.

Comme indiqué ci-dessus le nombre de cycles de fonctionnement à partir duquel des défauts de ce type interviennent est généralement élevé, et des essais ont montré que le comportement de ces cellules suite à des défauts de ce type est toujours le même :
- les défaillances se produisent systématiquement lors d'opérations d'effacement au sens EPROM, c'est à dire lors du retour des charges vers le substrat,
- les défaillances détectées lors de cycles écriture-effacement successifs dans une même cellule, ne sont pas immédiatement destructrices.

Lorsqu'une opération de relecture consécutive à un effacement montre que cet effacement n'a pas produit l'effet escompté, l'expérience montre qu'il suffit de générer un deuxième effacement pour y parvenir. De plus, ceci est reproductible un grand nombre de fois, c'est à dire que lorsqu'une cellule a une première défaillance son effacement nécessitera par la suite systématiquement deux cycles d'effacement pour obtenir un effacement correct.

Au fur et à mesure de la sollicitation du point mémoire, ces défaillances en effacement deviennent de plus en plus fréquentes de telle sorte qu'après une phase à deux effacements, il devient nécessaire d'effectuer des effacements en trois cycles pour obtenir le résultat escompté. Là encore un grand nombre de cycles à trois effacements est possible avant que des cycles à quatre effacements soient nécessaires etc... Le procédé d'effacement de points mémoire selon l'invention utilise ces caractéristiques pour optimiser le fonctionnement du point mémoire en effacement et simultanément donner à l'extérieur une information caractéristique à chaque instant du fonctionnement.

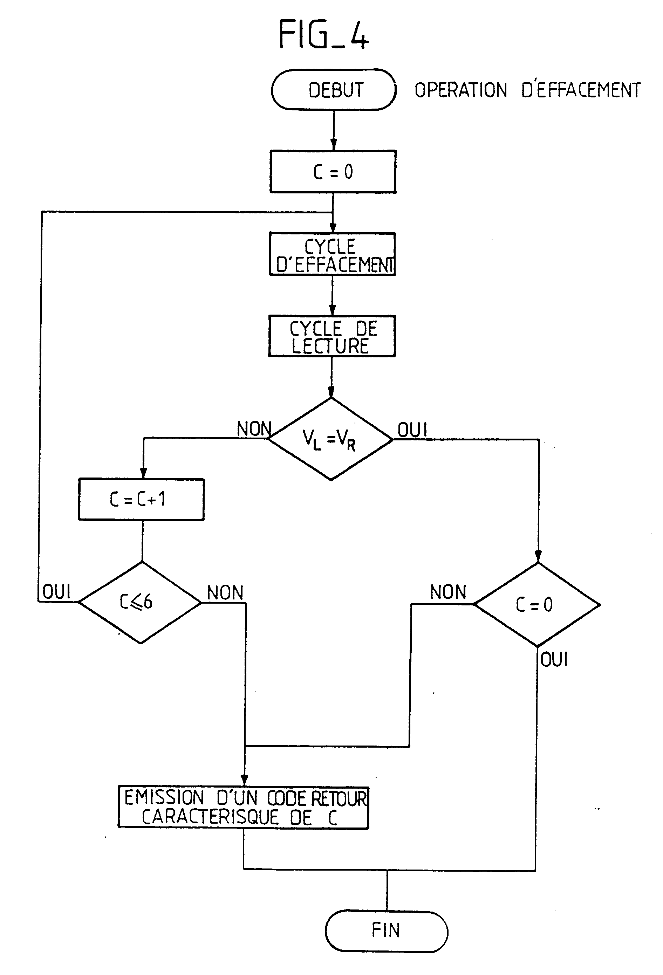

La figure 4 illustre le procédé d'effacement selon l'invention. Comme il a été indiqué ci-dessus les défauts sont générés lors de l'effacement. En conséquence, chaque opération d'effacement commence systématiquement par un cycle d'effacement normal tel qu'il est préconisé dans les caractéristiques du produit, suivi d'un cycle de lecture, un compteur dans le processeur de l'application étant ouvert pour ce point mémoire à la valeur C = O au début de chaque opération d'effacement. Lorsque la tension lue V_{L} est égale à la tension de référence attendue V_{R} , un test sur la valeur de C permet de vérifier lorsque C = O qu'aucun effacement antérieur n'a eu lieu pour ce point dans cette opération d'effacement, et l'effacement est considéré comme correct.

Si par contre la tension lue V_{L} est différente de la tension attendue V_{R} , alors le contenu du compteur ouvert dans le processeur de l'application est incrémenté : C = C + 1. La valeur de C est ensuite comparée à un nombre d'effacements maximum possible, soit six par exemple, au delà duquel le point est considéré comme définitivement ineffaçable. Tant que le contenu du compteur est inférieur ou égal à six, un nouveau cycle effacement et lecture est déclenché pour ce même point mémoire. Après le deuxième cycle d'effacement ou éventuellement le troisième ou le quatrième, la tension lue étant égale à la tension de référence, le test sur la valeur de C montre que C est différent de zéro, c'est à dire que plusieurs cycles d'effacement ont été nécessaires pour obtenir la bonne tension de référence, et l'émission d'un code retour est déclenché à destination de l'application utilisant le processeur, le code retour étant caractéristique du nombre d'effacements qui a été nécessaire pour l'obtention de la tension de référence caractéristique d'un effacement correct. L'effacement est alors considéré comme correctement effectué.

Si le contenu du compteur ouvert dans le processeur de l'application montre que pour cette opération d'effacement le nombre de cycles nécessaires a atteint la valeur limite, six dans l'exemple indiqué ci-dessus, l'effacement n'est pas réalisé et le processeur déclenche l'émission d'un code retour caractéristique de cette valeur de compteur, indiquant que le point mémoire n'a pas pu être effacé.

L'opération d'effacement est alors terminée bien que la valeur de tension obtenue soit incorrecte.

Un effacement supplémentaire dit de sécurité peut être prévu lorsque plusieurs cycles d'effacement ont été nécessaires pour effacer un point mémoire.

L'émission d'un code retour caractéristique du nombre de cycles d'effacement qui ont été nécessaires pour obtenir un effacement correct, permet de signaler à l'utilisateur avec quelle urgence il doit procéder au remplacement de la mémoire. Ainsi, selon l'invention le procédé d'effacement de points mémoire ne consiste pas à modifier le cycle d'effacement proprement dit tel qu'il est prévu par le constructeur, mais consiste à le répéter tant que nécessaire jusqu'à ce que l'opération d'effacement soit effectivement réalisée, en actualisant à chaque nouveau cycle d'effacement commandé le contenu d'un compteur ouvert à cet effet lors de l'utilisation du produit, soit dans le processeur du produit lui même, par exemple dans le processeur de la carte à microcircuit, soit dans le processeur de l'application, au début de l'opération d'effacement. Un circuit logique très simple utilisant le contenu de ce compteur permet de générer un signal de retour fonction de l'état du point mémoire, au moment de l'opération de l'effacement qui vient d'être réalisée.

La figure 5 illustre le dispositif destiné à la mise en oeuvre du procédé d'effacement tel que décrit ci-dessus.

La mémoire EEPROM 10, constituée d'un ensemble de points mémoire effaçables tels que décrits ci-dessus est, en dehors des phases de service pour l'application, non alimentée. En service et/ou lors de son inscription ou de son effacement la mémoire 10 est connectée à un circuit à microprocesseur, celui de l'application. Ce circuit comporte un processeur 20 qui gère la mémoire 10, carte à microcircuit par exemple, avec son horloge H, ses mémoires à accès aléatoires associées, de données RAM, et d'autres instructions enregistrées en mémoire morte PROM, et les circuits d'entrées/sorties, E/S. La génération des codes retour est déclenchée par le processeur qui contrôle l'état de comptage du compteur dans la RAM. L'état de ce compteur peut changer fréquemment, d'une cellule à l'autre, puisque sa technologie le lui permet.

Le processeur commande aussi des moyens logiques 30 de génération de code retour, fonction de l'état du compteur ouvert dans la RAM. Ces moyens logiques 30 peuvent être portés par le dispositif à mémoire lui-même comme représenté sur la figure 5. Plutôt que de ne délivrer qu'un seul message, celui de l'échec de l'effacement au bout de six essais par exemple, les codes retour peuvent correspondre à des mises en garde de plus en plus pressantes au fur et à mesure que le compteur de la RAM s'incrémente. Le nombre des messages ainsi que leur teneur renseignent l'utilisateur sur les précautions ultérieures à prendre avec la mémoire ainsi contrôlée.

## Revendications

1. Procédé d'effacement de point mémoire EEPROM (10), caractérisé en ce qu'il consiste :
- à ouvrir et initialiser un compteur dans une mémoire à accès aléatoire associée à un processeur de commande d'effacement (20) au début de chaque opération d'effacement d'un point mémoire,
- à effectuer un cycle d'effacement, puis un cycle de lecture et une comparaison de la tension lue (V_{L}) avec une tension attendue (V_{R}) correspondant à l'état effacé,
- à déclencher lorsque les deux tensions sont différentes l'itération du compteur et un nouveau cycle d'effacement et lecture, puis une comparaison, tant que le contenu du compteur reste inférieur à un nombre prédéterminé,
- à commander l'émission d'un code retour vers l'application fonction du contenu du compteur, et donc du nombre de cycles d'effacement nécessaires à l'opération d'effacement, lorsque la tension lue est la tension attendue après au moins 2 cycles d'effacement, ainsi que lorsque le contenu du compteur à atteint le nombre prédéterminé.

2. Procédé selon la revendication 1, caractérisé en ce qu'un cycle d'effacement supplémentaire, de sécurité est commandé avant l'émission du code retour lorsque la tension lue est la tension attendue et que le contenu du compteur est différent de zéro, plusieurs cycles d'effacement ayant été nécessaires pour obtenir la tension attendue.

3. Dispositif destiné à la mise en oeuvre du procédé d'effacement de point mémoire EEPROM (10) selon l'une des revendications 1 et 2, caractérisé en ce qu'il comporte la mémoire (10) constituée de points mémoire de type EEPROM associée à un processeur (20) lors de son utilisation dans une application, en ce que le compteur est ouvert au début de chaque opération d'effacement dans la mémoire à accès aléatoire (RAM) du processeur, et en ce qu'il comporte en outre des moyens logiques (30) pour déclencher, lorsqu'il y a lieu, l'émission d'un code retour fonction de l'état du compteur en fin d'opération d'effacement.

4. Utilisation du procédé d'effacement selon l'une des revendications 1 et 2, pour un dispositif à mémoire constituée de points mémoire EEPROM (10) non alimenté en dehors des phases de service.

5. Utilisation du procédé d'effacement selon la revendication 4 pour un dispositif à mémoire du type carte microcircuit.

## Patentansprüche

1. Verfahren zum Löschen von EEPROM-Speicherzellen (10), dadurch gekennzeichnet, daß es darin besteht:
- einen Zähler in einem Speicher mit wahlfreiem Zugriff, welcher einem Löschsteuerprozessor (20) zugeordnet ist, am Anfang einer jeden Operation des Löschens einer Speicherzelle zu setzen und zu initialisieren,
- einen Löschzyklus, dann einen Lesezyklus sowie einen Vergleich der gelesenen Spannung (V_{L}) mit einer erwarteten Spannung (VR), die dem gelöschten Zustand entspricht, auszuführen,
- dann, wenn die beiden Spannungen verschieden sind, die Iteration des Zählers und einen neuen Lösch- und Lesezyklus und dann einen Vergleich auszulösen, solange der Inhalt des Zählers kleiner als eine vorgegebene Zahl bleibt,
- die Sendung eines Rückkehrcodes zur Anwendung in Abhängigkeit vom Inhalt des Zählers und daher von der Anzahl der für die Löschoperation notwendigen Löschzyklen zu steuern, wenn die gelesene Spannung nach wenigstens 2 Löschzyklen die erwartete Spannung ist und wenn der Inhalt des Zählers die vorgegebene Zahl erreicht hat.

2. Verfahren gemäß Anspruch 1, dadurch gekennzeichnet, daß vor dem Senden des Rückkehrcodes ein zusätzlicher Sicherheits-Löschzyklus befohlen wird, wenn die gelesene Spannung die erwartete Spannung ist und der Inhalt des Zählers verschieden von Null ist, sofern mehrere Löschzyklen notwendig gewesen sind, um die erwartete Spannung zu erhalten.

3. Einrichtung, die für die Ausführung des Verfahrens zum Löschen von EEPROM-Speicherzellen (10) gemäß den Ansprüchen 1 und 2 bestimmt ist, dadurch gekennzeichnet, daß sie den Speicher (10) enthält, der aus Speicherzellen vom EEPROM-Typ gebildet ist und bei seiner Verwendung in einer Anwendung einem Prozessor (20) zugeordnet ist, daß der Zähler am Anfang einer jeden Löschoperation im Speicher mit wahlfreiem Zugriff (RAM) des Prozessors gesetzt wird und daß sie außerdem Logikmittel (30) enthält, um gegebenenfalls das Senden eines Rückkehrcodes in Abhängigkeit vom Zustand des Zählers am Ende der Löschoperation auszulösen.

4. Verwendung des Löschverfahrens gemäß einem der Ansprüche 1 und 2 für eine Speichereinrichtung, die aus EEPROM-Speicherzellen (10) gebildet ist und außerhalb der Betriebsphasen nicht versorgt wird.

5. Verwendung des Löschverfahrens gemäß Anspruch 4 für eine Speichereinrichtung des Typs einer Mikroschaltungskarte.

## Claims

1. Erasure procedure for EEPROM memory cells (10), characterised in that it consists of the following operations:
-- opening and initializing a counter in a random access memory associated with an erasure control processor (20) at the beginning of each memory cell erasure operation;
-- effecting an erasure cycle followed by a reading cycle and a comparison of the voltage read (V_{L}) with an expected voltage (V_{R}) corresponding to the erased state;
-- effecting, when the two voltages are different, the iteration of the counter and a further erasure and reading cycle, as long as the content of the counter remains below a certain predetermined number;
-- operating the mission of a code for return to the application which is a function of the content of the counter and thus of the number of erasure cycles required for the erasure operation, when the voltage read is the voltage expected after at least two erasure cycles and also when the content of the counter has reached the predetermined number.

2. Procedure in accordance with claim 1, characterised in that a supplementary erasure cycle for safety is effected before the emission of the return code when the voltage read is the voltage expected and when the content of the counter is different from zero, a number of erasure cycles having been necessary in order to obtain the voltage expected.

3. Device intended for the implementation of the EEPROM memory cell erasure procedure (10) in accordance with either one of claims 1 and 2, characterised in that it comprises the memory (10) consisting of memory cells of the EEPROM type associated with a processor (20) when it is used in an application, and that the counter is open at the beginning of each erasure operation in the random access memory (RAM) of the processor, and that it also comprises logic means (30) for effecting, when appropriate, the emission of a return code which is a function of the state of the counter at the end of the erasure operation.

4. Use of the erasure procedure according to either claims 1 and 2, for a memory device consisting of EEPROM memory cells (10) not fed outside the service phases.

5. Use of the erasure procedure according to claim 4 for a memory device of the microcircuit card type.
